# EUROPEAN PATENT APPLICATION

(11) **EP 1 609 879 A1**
(43) Date of publication of application: **28.12.2005**
(21) Application number: 05011197.0
(22) Date of filing: 24.05.2005
(51) Int. Cl.: C23C 14/04

(54) **Method for producing a mask**

(30) Priority: 21.06.2004 JP 2004182459
(71) Applicant: SEIKO EPSON CORPORATION, Shinjuku-ku, Tokyo 163-0811 (JP)
(72) Inventor: Yotsuya, Shinichi, Suwa-shi Nagano-ken 392-8502 (JP)
(74) Representative: HOFFMANN EITLE

(57) **Abstract**

A mask (10) comprises a first portion (11d) having an opening (12) and a second portion (11c) disposed in the opening and surrounded by the opening. A beam connects the first portion (11d) to the second portion (11c). The method for producing such a mask comprises the steps of etching part of an opening forming portion not including a beam forming portion, the opening forming portion corresponding to the region where an opening is to be formed, and the beam forming portion corresponding to the region where a beam that divides the opening forming portion into a plurality of segments is to be formed, and the step of etching the entire opening forming portion in the same direction as in the preceding step.

## Description

### BACKGROUND OF THE INVENTION

### 1. Technical Field

The present invention generally relates to masks for forming desired wiring patterns on substrates by vapor-phase deposition or the like.

### 2. Related Art

Techniques of forming electrical wiring on substrates by photolithography and dry and wet etching have been widely practiced. However, photolithographic processes and etching processes require expensive equipment, and the production costs are also high due to low yield and administration costs required to control a plurality of steps. Furthermore, use of large amounts of resists, developing solutions, resist removers, and etching solutions (gas) may cause environmental problems. When the substrates are not flat, i.e., when holes and grooves are formed in the substrates, it becomes difficult to form resist coatings or high precision patterns.

In this connection, Japanese Unexamined Patent Application Publication No. 4-236758 discloses a technique of forming a desired wiring pattern on a substrate by vapor-phase deposition while placing a substrate into close contact with a patterned mask, such as a silicon wafer or metal foil. This technique is particularly useful for production of organic electroluminescence (EL) materials which use large amounts of materials easily degradable by moisture, oxygen, or the like.

However, application of this technique is limited to masks with relatively simple patterns, such as rectangular patterns and circular patterns. For example, it is difficult to form complicated patterns, such as wiring patterns, by this technique. In particular, this technique is not suitable for forming a wiring pattern inside another wiring pattern.

### SUMMARY

An advantage of the invention is to provide a mask capable of forming a complicated circuit wiring pattern by mask deposition, and a method for making such a mask.

According to an aspect of the invention, a mask includes a first portion having an opening, a second portion disposed in the opening and surrounded by the opening, and a beam connecting the first portion to the second portion. According to this aspect of the invention, an opening having a complicated shape can be formed. For example, a closed pattern can be formed. Furthermore, a continuous thin film pattern may be formed on a substrate using this mask. Particles of a material for forming a film can be deposited on the substrate in an angled direction; thus, a mask having finer openings can be formed.

Preferably, the thickness of the beam is smaller than the thickness of other portions of the mask so that particles of the material for making the thin film can reach the substrate in an angled direction. Thus, a mask with a finer pattern opening can be prepared. Preferably, the mask is composed of silicon since the opening and the beam can be formed with high reliability.

Another aspect of the invention provides a method for producing.a mask for forming a patterned thin film on a substrate. The method includes (a) etching part of an opening forming portion not including a beam forming portion, the opening forming portion corresponding to the region where an opening is to be formed, and the beam forming portion corresponding to the region where a beam that divides the opening forming portion into a plurality of segments is to be formed; and (b) etching the entire opening forming portion in the same direction as in step (a).

According to this aspect, a mask that has a beam connecting the side walls that define the opening and being located at a predetermined distance away from a surface of the mask can be formed with reliability.

The method may further include (c) etching the mask in a different direction from that in steps (a) and (b) to form an opening that penetrates the mask. In this manner, the thickness and the strength of the mask can be adequately adjusted. The mask is preferably composed of silicon and anisotropic etching is preferably performed in steps (a) and (b) so that an opening with a beam can be reliably formed.

A yet another aspect of the invention provides a method for depositing a patterned thin film on a substrate. The method includes depositing a thin film using a mask having a first portion having an opening, a second portion disposed in the opening and surrounded by the opening, and a beam connecting the first portion to the second portion. According to this method, a patterned thin film having a continuous complicated shape can be formed on the substrate.

The thin film is preferably a metal film. In this manner, a continuous metal wiring can be formed. The metal thin film is preferably composed of a plurality of types of metal since the resistance of the metal wiring can be reduced, and good electrical conduction can be ensured. The mask is preferably reused by removing the material deposited on the mask. In this manner, high-performance electronic devices can be produced at low costs.

Another aspect of the invention provides an electronic device including a metal wiring pattern prepared as above. According to this aspect, continuous metal wiring having a complicated shape can be produced at lower costs. Thus, high performance electronic devices can be produced at low costs.

Another aspect of the invention provides an electronic apparatus having the electronic device described above. According to this aspect, a high performance electronic apparatus can be produced.

### BRIEF DESCRIPTION OF THE DRAWINGS

The invention will be described with reference to the accompanying drawings, wherein like numbers reference like elements, and wherein:
Fig. 1 is a partial perspective cross-sectional view of a mask 10;
Figs. 2A-2I show steps of producing the mask 10;
Fig. 3 shows a deposition process using the mask 10;
Fig. 4 shows the pattern of a metal wiring 52;
Fig. 5 is a side cross-sectional view of an organic EL device 100; and
Fig. 6 shows an electronic device according to one embodiment.

### DESCRIPTION OF THE EMBODIMENTS

A mask, a method for making the mask, a deposition method, an electronic device, and an electronic apparatus according to various embodiments of the invention will now be described with reference to the attached drawings.

### [Mask]

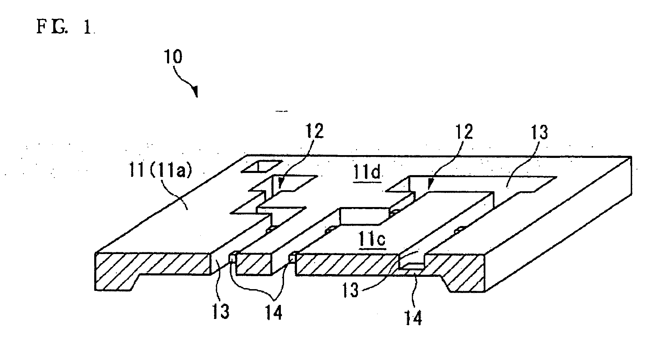

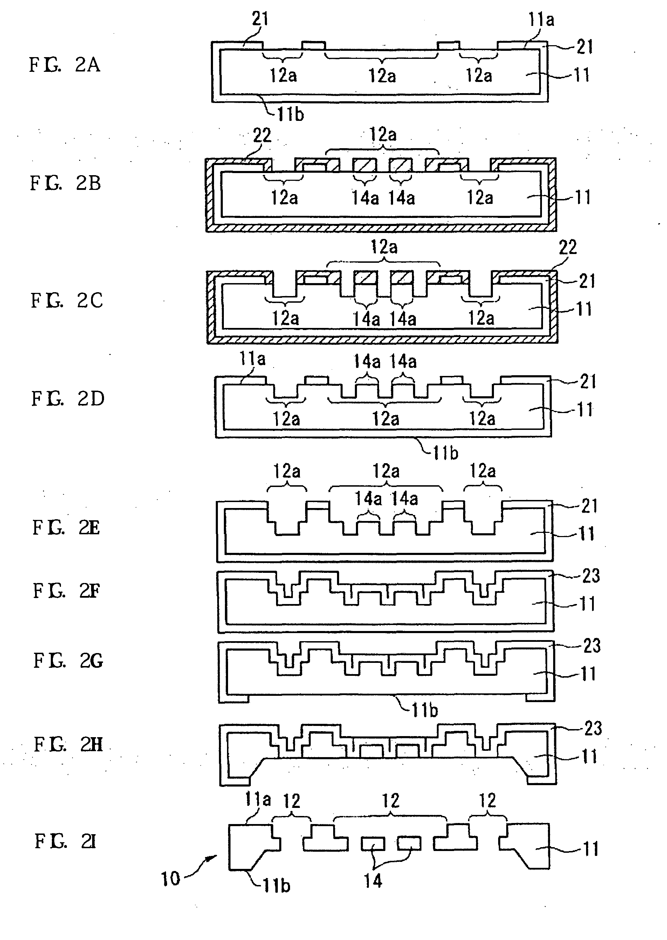

Fig. 1 is a partial perspective cross-sectional view showing a mask 10 used in forming a patterned thin film on a substrate by a deposition process, a sputtering process, a CVD process, or the like. The mask 10 includes a mask substrate 11 composed of silicon and a plurality of openings 12. An example of the shape of the pattern opening 12 is a line having a width of approximately 10 µm. When a metal material is deposited on a substrate through this pattern opening 12, a pattern, such as an electrical wiring, having a width of approximately 10 µm can be formed. The shape of the pattern opening 12 is not limited to lines and may be circular, rectangular, or the like.

In each pattern opening 12, beams connecting opposing side walls 13 of the pattern opening 12 are disposed. The beams 14 are disposed at positions distant from the opposing surface (hereinafter referred to as "surface 11a") of the mask substrate 11. The distance between the surface 11a and the beams 14 is at least 5 µm. Since the beams 14 are disposed on the side walls 13 of the pattern openings 12, it becomes possible to form closed pattern openings in the mask substrate 11. For example, a ring-shaped pattern opening 12 can be formed by suspending the centerpiece using the beams 14. In particular, a segment 11c of the mask substrate 11 in Fig. 1 is attached to a segment 11d of the mask substrate 11 using the beams 14. Thus, the segment 11c does not separate from the mask substrate 11, thereby forming part of the mask 10. Note that the number of the beams 14 used may be suitably adjusted according to the strength and the like of the beams.

The reason for forming the beams 14 distant from the surface 11a is to form continuous metal wiring on the substrate without any break using the mask 10. In other words, when the beams 14 are distant from the surface 11a, for example, the material for the metal wiring can travel around the beams to thereby sufficiently reach the desired portion of the substrate. The steps of forming the metal wiring will be described below.

The mask substrate 11 may be composed of metal, glass, plastic, or the like. Preferably, the mask substrate 11 is a silicon plate, such as a silicon wafer, since formation of the beams 14 are easier as will be described below in connection with the production process. The mask substrate 11 may be of any shape but preferably has a thickness of several hundred micrometers.

### [Process for producing mask]

The process for producing the mask 10 above will now be described. Figs. 2A to 2I show steps of the process for producing the mask 10.

First, an oxide film (SiO₂ film) 21 that acts as a dry etching-resistive mask is deposited on the entire surface of the mask substrate 11. In particular, the oxide film 21 is deposited by steam thermal oxidation that involves leaving the mask substrate 11 in steam at 1,050°C. The material of the film to be deposited may be any material that functions as a mask against anisotropic etching described below. Examples of such a material include silicon nitride, silicon carbide, aluminum, and chromium. The deposition process may be vapor deposition, sputtering, plating, CVD, or the like.

Referring to Fig. 2A, portions corresponding to the openings 12 are removed from the oxide film 21 on the surface of the mask substrate 11. These portions in the mask substrate 11 exposing the surface 11a as a result of the removal of the oxide film become the openings 12. These portions are referred to as "opening forming portions 12a".

Referring now to Fig. 2B, a resist is applied on the mask substrate 11 to form a resist layer 22. Portions corresponding to the openings 12 but excluding portions corresponding to the beams 14 are then removed from the resist layer 22 on the surface 11a by photolithography. In other words, a resist is applied on the portions where the beams 14 are to be formed (hereinafter, these portions are referred to as the "beams forming portions 14a"). The beams forming portions 14a are located inside the opening forming portions 12a exposed in the previous step. In this manner, each opening forming portion 12a is exposed as if it is divided into a plurality of segments.

Next, the mask substrate 11 is anisotropically etched in a particular direction, i.e., in a substantially orthogonal direction with respect to the surface 11a of the mask substrate 11. Referring now to Fig. 2C, the silicon substrate is uniformly etched to a predetermined depth as a result. In other words, the silicon material in the portions corresponding to the openings 12 that do not include the portions corresponding to the beams 14 (the opening formation portions 12a other than the beams forming portions 14a) is etched away.

Referring now to Fig. 2D, the resist layer on the mask substrate 11 is removed by oxygen plasma treatment or the like. The mask substrate 11 without the resist is again anisotropically etched. As a result, the portion that has already been etched in the previous step is uniformly etched further. Among the portions exposed by the removal of the resist, portions not covered with the oxide layer 21 are also etched to uniformly remove the silicon material in these portions. The resulting mask substrate 11 has two-step irregularities, as shown in Fig. 2E.

Note that the silicon portions etched for the first time in this step are the portions corresponding to the beams 14 (beams forming portions 14a). These portions are anisotropically etched to have a predetermined depth from the surface 11a of the mask substrate 11. As has been previously mentioned, the distance to the beams from the surface 11a is preferably about 5 µm or more.

Next, the oxide film 21 covering the mask substrate 11 is removed, and an oxide film 23 is formed to cover all the surfaces of the mask substrate 11, as shown in Fig. 2F. The oxide film 23 on a rear surface 11b of the mask substrate 11 is partly removed to expose central portion of the mask substrate 11, as shown in Fig. 2G

Referring now to Fig. 2H, the mask substrate 11 is wet-etched to a predetermined depth so as to uniformly remove the silicon material in the central portion of the mask substrate 11. Here, anisotropic etching (dry etching) may be performed instead of wet etching.

Lastly, the oxide film 23 on the mask substrate 11 is removed to form a plurality of openings in the mask substrate 11, as shown in Fig. 2I. Of the openings in the mask substrate 11, the openings in the surface 11a are openings 12 (opening forming portions 12a). The portions a predetermined distance away from the surface 11a are the beams 14 (beams forming portions 14a).

As is described above, the openings 12 and the beams 14 are formed by conducting two or more etching steps at the surface 11a of the mask substrate 11. The reason for etching the rear surface 11b of the mask substrate 11 is to minimize the thickness of the mask 10. The reason for leaving the thick peripheral portion of the mask substrate 11 is to ensure the strength of the mask substrate 11.

### [Deposition process]

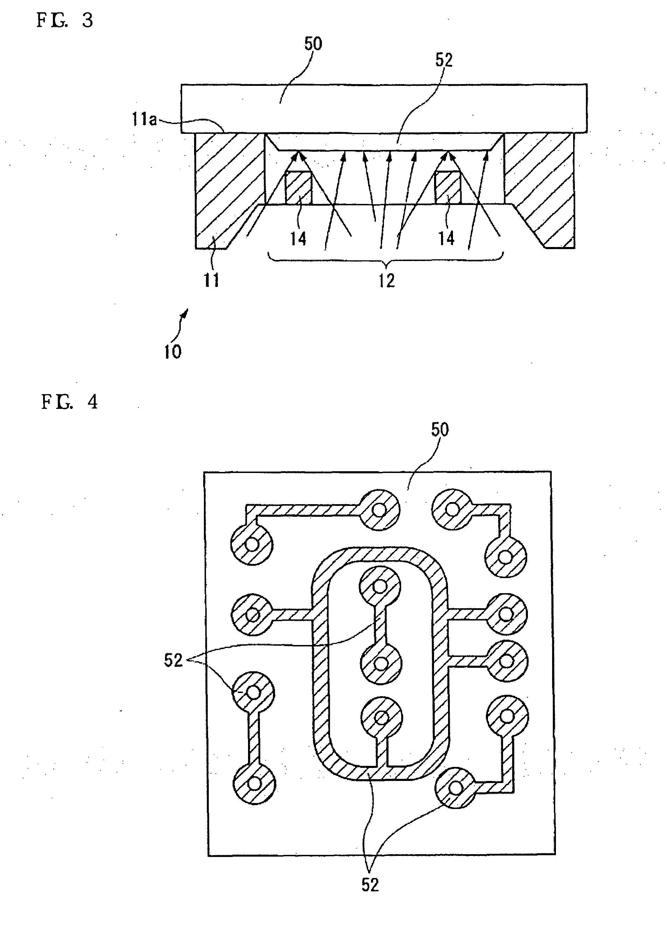

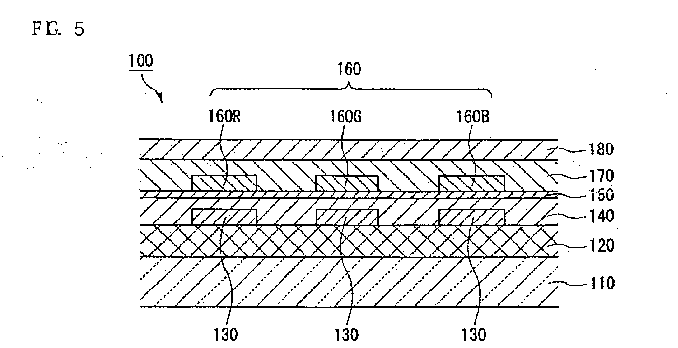

The process of forming a pattern, such as metal wiring 52, on a substrate 50 using the mask 10 above will now be described. Fig. 3 shows the deposition process using the mask 10. Fig. 4 shows the pattern of the metal wiring 52 formed by the deposition process.

The mask 10 is used to form a pattern, such as metal wiring 52, on the substrate 50 by physical vapor deposition, such as vapor-phase deposition or sputtering or by chemicophysical vapor deposition, such as CVD. In particular, the mask 10 is placed on the substrate 50 so that the surface 11a of the mask 10 is in contact with the substrate 50. A thin film of a predetermined material is then formed on the substrate 50 by physical vapor deposition or chemicophysical vapor deposition. As shown in Fig. 3, the material deposits on the substrate 50 through the openings 12 in the mask 10. The material travels around the beams 14 and deposit on the entire exposed portions of the substrate 50 corresponding to the openings 12. Since the metal wiring 52 can be can be formed without being affected by the presence of the beams 14, a continuous pattern of the metal wiring 52 free of breaks can be formed.

Accordingly, the closed pattern of the metal wiring 52 shown in Fig. 4, i.e., the pattern which has not been easily formed by the related art, can be advantageously formed. Note that in order for the material for the thin film to travel around the beams 14 and reach the surface of the substrate 50, the distance from the surface 11a of the mask 10 to the beams 14 needs to be at least about 5 µm, as described above. At a shorter distance, the amount of the material that travels around the beams 14 decreases, and the pattern, such as metal wiring 52, formed on the substrate 50 becomes thin, thereby increasing the resistance or causing disconnection.

In order to form the metal wiring 52 by forming a patterned thin film on the substrate 50, two or more metal materials are preferably deposited. For example, a low-resistance metal wiring 52 may be formed by depositing an aluminum film, zincating the aluminum film, performing electroless nickel plating, and then performing electroless gold plating. In this manner, a metal wiring 52 having a low resistance can be formed with a smaller amount of expensive gold.

The mask 10 used to form the patterned thin film may be reused by removing the material deposited on the rear surface 11b. The metal wiring 52 and the like can be formed at lower costs by the reuse of the mask 10.

### [Organic EL device]

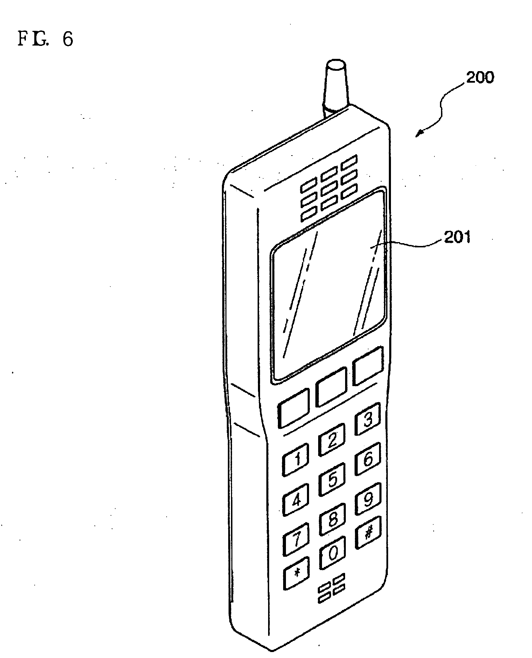

Fig. 5 is a side cross-sectional view of an organic EL device 100. The mask 10 includes pixel electrodes 130 acting as anodes, cathodes 180, and a plurality of pixel regions disposed between the anodes and the cathodes to form a matrix. Pixel regions include emission layers 160R, 160G, and 160B composed of organic materials.

On a surface of a substrate 110 composed of glass or the like, a circuit 120 for driving the pixel regions, i.e., the emission layers 160R, 160G, and 160B, are disposed. Although the detailed structure of the circuit 120 is not shown in Fig. 5, the electrical wiring in the circuit 120 is formed by the above-described deposition process.

On the surface of the circuit 120, the pixel electrodes 130 composed of indium tin oxide (ITO) or the like are disposed to form a matrix corresponding to the pixel regions. A hole injection layer 140 composed of copper phthalocyanine is disposed to cover the pixel electrodes 130 functioning as anodes. On the hole injection layer 140, a hole transport layer 150 composed of N,N-di(naphthalyl)-N,N-diphenyl-benzidene (NPB) is disposed.

On the hole transport layer 150, the emission layers 160R, 160G, and 160B are disposed to form a matrix corresponding to the pixel regions. Each emission layer may be composed of a low molecular weight-organic material having a molecular weight of approximately 1,000 or less. In particular, each emission layer is composed of a host material, such as tris(8-hydroxyquinoline)aluminum (Alq3), and a dopant, such as rubrene.

An electron injection layer 170 composed of lithium fluoride or the like is disposed to cover the emission layers 160. On the surface of the electron injection layer 170, the cathodes 180 composed of aluminum or the like are disposed. A sealing substrate (not shown in the drawing) is bonded to the edges of the substrate 110 to hermetically seal the entire composite. When a voltage is applied between the pixel electrodes 130 and the cathodes 180, holes are injected to the emission layers 160 through the hole injection layer 140, and electrons are injected to the emission layers 160 through the electron injection layer 170. Recombination of the holes and electrons occur in the emission layers 160, thereby exciting the dopant and achieving emission. The organic EL device 100 having the emission layers 160 composed of organic materials has longer lifetime and achieves higher emission efficiency.

### [Electronic device]

Fig. 6 shows an electronic device according to one embodiment of the invention. The device is a cellular phone 200 including a display 201. Other examples of the device include a wrist watch-type electronic device having a display including a low molecular weight-organic EL device 100 and portable information processing devices, such as word processors and personal computers, that use the low molecular weight-organic EL device 100 as a display.

The cellular phone 200 having the display 201 including the low molecular weight-organic EL device has high display contrast with high quality display.

Although the invention has been described heretofore by way of preferred embodiments with reference to the attached drawings, the scope of the invention is not limited to these embodiments. The shapes, combination, and the like of the constituent elements described in the above examples are mere examples, and various modifications and alteration are possible depending on design matter without departing from the scope of the invention.

## Claims

1. A mask (10) comprising:
a first portion (11c) having an opening (12);
a second portion (11d) disposed in the opening and surrounded by the opening; and
a beam (14) connecting the first portion (11c) to the second portion (11d).

2. The mask according to claim 1, wherein the thickness of the beam (14) is smaller than the thickness of other portions (11; 11a, 11c, 11d) of the mask (10).

3. The mask according to claim 1 or 2, wherein the mask (10) comprises silicon.

4. A method for producing a mask for forming a patterned thin film on a substrate, the method comprising:
(a) etching part of an opening forming portion not including a beam forming portion, the opening forming portion corresponding to the region where an opening is to be formed, and the beam forming portion corresponding to the region where a beam that divides the opening forming portion into a plurality of segments is to be formed; and
(b) etching the entire opening forming portion in the same direction as in step (a).

5. The method according to claim 4, further comprising:
(c) etching the mask in a different direction to form an opening that penetrates the mask.

6. The method according to claim 4 or 5, wherein the mask comprises silicon, and, in steps (a) and (b), anisotropic etching is performed.

7. A method for depositing a patterned thin film on a substrate, the method comprising:
depositing a thin film using a mask having a first portion having an opening, a second portion disposed in the opening and surrounded by the opening, and a beam connecting the first portion to the second portion.

8. The method according to claim 7, wherein the thin film is a metal thin film.

9. The method according to claim 8, wherein the metal thin film is prepared by depositing a plurality of types of metal.

10. The method according to any of the claims 7 to 9, wherein the mask is reused by removing the material deposited on the mask.

11. An electronic device comprising a metal wiring pattern prepared by the method according to any of the claims 7 to 10.

12. An electronic apparatus comprising the electronic device according to claim 11.
